# FASCICULE DE BREVET EUROPEEN

(11) **EP 4 053 884 B1**
(45) Date de publication et mention de la délivrance du brevet: **15.11.2023**
(21) Numéro de dépôt: 22158665.4
(22) Date de dépôt: 24.02.2022
(51) Int. Cl.: H01L 21/311, H01L 29/66

(54) **PROCÉDÉ DE GRAVURE D'UNE COUCHE DIÉLECTRIQUE TRIDIMENSIONNELLE**
VERFAHREN ZUM ÄTZEN EINER DIELEKTRISCHEN DREIDIMENSIONALEN SCHICHT
METHOD FOR ETCHING A THREE-DIMENSIONAL DIELECTRIC LAYER

(30) Priorité: 25.02.2021 FR 2101865
(43) Date de publication de la demande: 07.09.2022
(73) Titulaire: Commissariat à l'énergie atomique et aux énergies alternatives, 75015 Paris (FR)
(72) Inventeur: POSSEME, Nicolas, 38054 GRENOBLE Cedex 09 (FR); BACQUIE, Valentin, 38054 GRENOBLE Cedex 09 (FR)
(74) Mandataire: Hautier IP

(56) Documents cités:
- EP-B1- 3 107 125
- EP-B1- 3 506 336

## Description

La présente invention concerne en général la gravure de couches sur des structures microélectroniques, notamment tridimensionnelles (3D).

Elle trouve pour application particulièrement avantageuse la réalisation de transistors de type FinFET, c'est-à-dire de transistors à effet de champ (FET) dont le canal de conduction comprend une lamelle verticale d'un matériau semi-conducteur, qualifiée du terme anglais de « fin ».

### ETAT DE LA TECHNIQUE

Pour améliorer les performances électriques des transistors, des architectures tridimensionnelles (3D) ont été développées. C'est par exemple le cas des architectures de transistors à base de nanofils et des architectures FinFET.

Un enjeu important des procédés de fabrication des transistors présentant une architecture 3D est la maîtrise de la gravure des espaceurs de ces transistors.

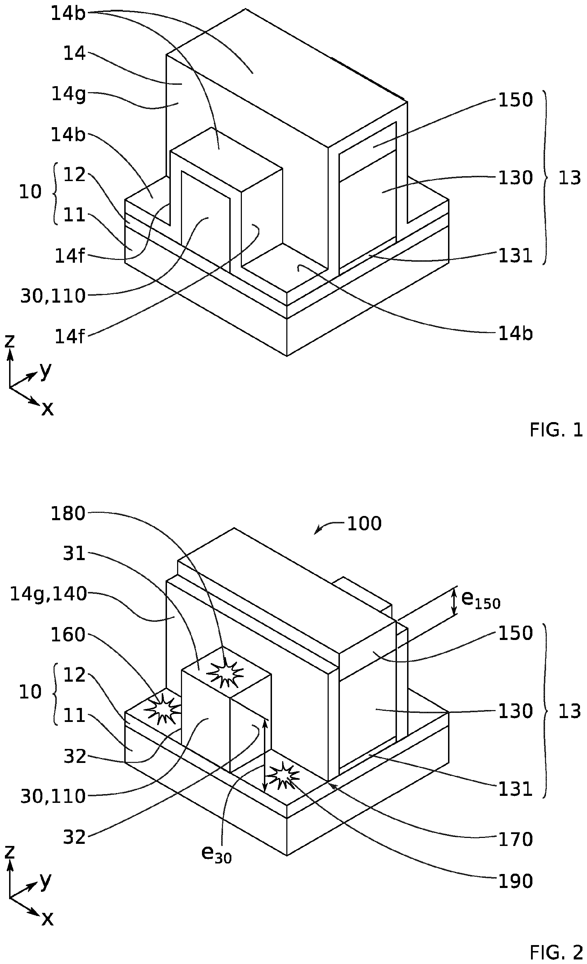

A titre d'exemple, un transistor 100 de type FinFET est illustré aux figures 1 et 2, respectivement avant gravure des espaceurs et après gravure des espaceurs. Dans cette architecture 3D, le canal 110 de conduction est constitué d'une lamelle verticale de matériau semi-conducteur, typiquement du silicium. La lamelle formant le canal 110 est entourée sur trois côtés par le motif de grille 13. La lamelle traverse de part en part le motif de grille 13 et se prolonge pour former de part et d'autre du motif de grille 13 des nageoires ou «Fin» 30. Ces Fin constituent ainsi des structures tridimensionnelles (3D).

Pour former les espaceurs 140 sur les flancs du motif de grille 13, un dépôt conforme d'une couche 14 en un matériau diélectrique est d'abord effectué sur le motif de grille 13 et le Fin 30 (figure 1).

Comme illustré sur la figure 2, la gravure de la couche diélectrique 14 est idéalement configurée pour retirer les portions basales 14b et les portions latérales de Fin 14f en conservant les seules portions latérales de grille 14g formant les espaceurs 140. Ainsi, toutes les autres portions de couche 14, en particulier celles couvrant le Fin 30, qu'elles soient perpendiculaires ou parallèles au plan basal XY du substrat 10, doivent être gravées complètement. Ceci doit être effectué sans laisser 190 de résidus et sans endommager 160 les couches sous-jacentes à la couche diélectrique 14, typiquement sans endommager 180 le sommet 31 des Fin 30 et/ou sans endommager la face supérieure du BOX 12 (acronyme de « burried oxide » ou oxyde enterré en français). Par ailleurs il est important que la gravure soit anisotrope selon z de façon à éviter 170 la formation de pieds à la base des espaceurs 140.

Le document EP 3506336 B1 prévoit un procédé de gravure de la couche diélectrique permettant de former de tels espaceurs en répétant plusieurs séquences d'étapes d'oxydation et de gravure. Ce procédé vise à consommer la couche diélectrique sur les flancs du Fin tout en protégeant le sommet du Fin.

En pratique cependant, la mise en oeuvre de ce procédé de gravure ne s'avère pas optimale. Le sommet du Fin reste impacté. Un retrait de matière couramment appelé « recess » est typiquement observé au sommet du Fin sur une profondeur de 1 à 2 nm. La précision en profondeur de gravure et/ou l'arrêt de gravure restent ainsi perfectibles.

Il existe donc un besoin consistant à proposer une solution pour graver entièrement et avec une grande précision une couche diélectrique située sur des faces d'une structure 3D tout en évitant d'endommager cette structure 3D.

Un objet de la présente invention est de pallier les limitations des solutions connues.

Dans le cadre particulier et non limitatif des transistors de type FinFET, un objectif de la présente invention consiste à proposer une solution pour graver sur les Fins la couche diélectrique destinée à former des espaceurs sur les flancs de la grille, tout en évitant, voire en supprimant, les résidus de couche diélectrique de part et d'autre des Fins ainsi que la consommation de couches sous-jacentes à la couche diélectrique telle que la couche semi conductrice formant le Fin.

Un autre objet de la présente invention est de proposer un procédé de gravure d'une couche diélectrique permettant un meilleur contrôle de l'arrêt de gravure au sommet de structures tridimensionnelles telles que des Fin.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un procédé de gravure d'une couche diélectrique recouvrant au moins un sommet et un flanc d'une structure tridimensionnelle de préférence à base d'un matériau semi-conducteur.

Le procédé comprend une pluralité de séquences comprenant chacune au moins les étapes successives suivantes :
- une première gravure de la couche diélectrique, par plasma, en utilisant une chimie comprenant :
   ∘ au moins un premier composé à base de fluor (F) provenant de la dissociation d'au moins un composé pris parmi les composés fluorocarbonés CxFz ou CxHyFz, x, y et z étant des entiers non nuls, et
   ∘ au moins un deuxième composé pris parmi le SiwCI(2w+2) et le SiwF(2w+2) w étant un entier non nul,
   ∘ de l'oxygène (O).
   ladite première gravure étant effectuée de manière à :
   ∘ générer un bombardement ionique dirigé principalement selon une direction parallèle audit flanc,
   ∘ réguler la quantité de l'au moins un premier composé pour consommer tout ledit premier composé à base de fluor lors de cette première gravure de manière à interrompre la première gravure avant consommation de toute l'épaisseur de la couche diélectrique située sur le flanc et après avoir consommé toute l'épaisseur de la couche diélectrique située sur le sommet,
   ∘ former une première couche de protection à base d'oxyde sur le sommet de la structure tridimensionnelle et former une deuxième couche de protection à base d'oxyde sur la couche diélectrique située sur le flanc, une épaisseur e50a de la première couche de protection étant supérieure à une épaisseur e60a de la deuxième couche de protection,
- une deuxième gravure configurée pour retirer entièrement la deuxième couche de protection tout en conservant une portion d'épaisseur e50b de la première couche de protection.

Cette séquence de première et deuxième gravures est répétée jusqu'au retrait complet de la couche diélectrique située sur le flanc de la structure.

La deuxième gravure est effectuée par plasma à base d'hydrogène (H2 ouNH3).

Ainsi, la présente invention propose une solution efficace pour graver entièrement et avec une grande précision la couche diélectrique sur le sommet et les flancs d'une structure 3D tout en évitant d'endommager cette structure 3D.

Typiquement, la gravure de la couche diélectrique selon cette séquence d'étapes est telle que l'on peut contrôler l'arrêt sur une couche de silicium sous-jacente à une échelle atomique.

En effet, la chimie utilisée lors de la première gravure, combinant espèces fluorées ou fluorocarbonées et au moins un gaz à base de silicium permet de graver efficacement la couche diélectrique, avec une forte sélectivité par rapport au matériau semi-conducteur de la structure 3D. Par ailleurs, cette gravure s'interrompt, lorsque toute l'espèce fluorée est consommée, avant gravure du matériau semi-conducteur de la structure 3D. La présence d'oxygène dans le plasma conduit à la formation d'une couche de protection dont l'épaisseur est plus importante sur le matériau semi-conducteur de la structure 3D que sur la couche diélectrique.

La deuxième gravure permet de retirer la couche de protection sur la couche diélectrique, tout en conservant une partie de cette couche de protection sur le matériau semiconducteur. Lors de la première gravure de la séquence suivante, le matériau semiconducteur sera donc protégé par le résidu de la première couche de protection ce qui empêchera la gravure de ce dernier, alors que la couche diélectrique ne sera plus protégée par la deuxième couche de protection. La couche diélectrique, mise à nu, se gravera donc aisément.

En répétant cette séquence d'étapes, on grave ainsi rapidement la couche diélectrique tout en consommant extrêmement peu, voire sans consommer le matériau semi-conducteur de la structure 3D.

Dans le cadre du développement de la présente invention, il a été observé que la deuxième gravure telle que divulguée par le document EP 3506336 B1 entraînait typiquement une amorphisation du matériau semi-conducteur au niveau du sommet de la structure 3D. La mise en oeuvre de la deuxième gravure selon le document EP 3506336 B1 est basée sur l'utilisation d'un plasma à base d'espèces fuorocarbonées. Il est apparu lors du développement de la présente invention que l'amorphisation du sommet de la structure 3D est due au bombardement ionique de ces espèces fuorocarbonées au travers de la couche de protection à base d'oxyde.

Pour limiter ou supprimer l'endommagement par amorphisation du sommet de la structure 3D, une première solution alternative à celle proposée dans la présente invention a été envisagée dans le cadre du développement de la présente invention. Cette solution alternative consiste à diminuer l'énergie des ions à base d'espèces fuorocarbonées lors de la deuxième gravure. Cette solution alternative n'a pas été retenue, parce qu'il a été observé, dans le cadre du développement de la présente invention, que cette solution entraîne lors de ladite deuxième gravure une dégradation du contrôle dimensionnel des espaceurs, également couramment appelé contrôle du CD ou simplement CD (acronyme de « Critical Dimension »).

Pour limiter ou supprimer l'endommagement par amorphisation du sommet de la structure 3D, une deuxième solution alternative à celle proposée dans la présente invention a été envisagée dans le cadre du développement de la présente invention. Cette deuxième solution alternative consiste à augmenter l'épaisseur de la première couche de protection, typiquement en allongeant la durée de la première gravure. Cette deuxième solution alternative n'a pas non plus été retenue, parce qu'il a été observé, dans le cadre du développement de la présente invention, que cette solution entraîne également une dégradation du CD des espaceurs lors de la deuxième gravure. En particulier, en allongeant la durée de la première gravure, une couche à base du deuxième composé se forme sur les surfaces sensiblement verticales de la couche diélectrique. Cette couche est ensuite éliminée lors de la deuxième gravure, ce qui consomme latéralement la couche diélectrique. Le CD est alors dégradé.

La présente invention se base au contraire sur un principe différent, qui consiste à employer des ions légers, en particulier des ions à base d'hydrogène, pour graver les première et deuxième couches de protection lors de la deuxième gravure. Les ions à base d'hydrogène ont pour avantage de ne pas amorphiser le sommet en matériau semiconducteur. Le sommet de la structure 3D est ainsi préservé d'un recess ultérieur.

En particulier, pour former le plasma utilisé lors de la deuxième gravure, aucun composé à base de Fluor n'est injecté dans le réacteur. La source d'hydrogène peut être typiquement du dihydrogène (H2) ou de l'ammoniac (NH3). Eventuellement, seuls des éléments chimiquement inertes (par exemple l'argon ou l'hélium) peuvent être introduits dans le réacteur pour favoriser la dissociation de la source d'hydrogène. On évitera de préférence d'utiliser des ions lourds pour former le plasma à base d'hydrogène, les ions étant considérés comme lourds lorsque leur masse atomique est supérieure ou égale à 40.

Avantageusement, au moins un effet supplémentaire est obtenu grâce à l'utilisation d'ions à base d'hydrogène. Lors de la gravure de la deuxième couche de protection et/ou après avoir gravé la deuxième couche de protection, les ions hydrogène sont également implantés dans une partie de la couche diélectrique sous-jacente à la deuxième couche de protection. Cela a pour effet de modifier le matériau diélectrique de cette partie de couche diélectrique sous-jacente. Dans les conditions de la première gravure, il est plus difficile de former une couche de protection à base d'oxyde sur le matériau diélectrique modifié. Ainsi, lors de la séquence suivante, la formation de la deuxième couche de protection sur la partie en matériau diélectrique modifié se trouve retardée. L'épaisseur de deuxième couche de protection est plus faible. Le retrait de cette deuxième couche de protection par la deuxième gravure suivante est alors plus rapide. L'implantation d'ions hydrogène dans la couche diélectrique sous-jacente est plus efficace.

Le matériau diélectrique modifié est en outre gravé plus facilement lors de la séquence suivante, dans les conditions de la première gravure. La vitesse de gravure globale de la couche diélectrique augmente.

Contrairement aux solutions connues, même optimisées, le procédé de gravure selon l'invention permet ainsi avantageusement d'améliorer significativement la protection du sommet de la structure 3D tout en augmentant la vitesse de gravure de la couche diélectrique sur les flancs de la structure 3D.

Lorsque la structure 3D est destinée à former un transistor de type FinFET, la présente invention propose ainsi une solution efficace pour graver la couche diélectrique déposée sur les Fins, tout en évitant, voire en supprimant, un recess des couches sous-jacentes à la couche diélectrique, en particulier au niveau du sommet des Fins.

Un autre aspect de la présente invention concerne un procédé de réalisation d'un transistor FinFET surmontant un substrat de support, le transistor FinFET comprenant un motif de grille et au moins un canal traversant le motif de grille et s'étendant depuis un flanc du motif de grille pour former au moins une structure de préférence faite en un matériau semiconducteur, ladite structure présentant un sommet et au moins deux flancs.

Le procédé comprend :
- le dépôt, de préférence conforme, d'une couche diélectrique recouvrant le motif de grille et ladite structure,
- la gravure de la couche diélectrique en mettant en oeuvre le procédé selon l'un quelconque des modes de réalisation du procédé de gravure selon l'invention, de manière à retirer complètement la couche diélectrique située sur la structure formée par le canal.

De manière facultative, le procédé de réalisation d'un transistor FinFET peut comprendre au moins l'une quelconque des caractéristiques suivantes prises isolément ou en combinaison :
Selon un exemple de réalisation, le motif de grille comprend une grille et un masque dur recouvrant un sommet de ladite grille, la couche diélectrique étant déposée sur le masque dur, le masque dur présentant une épaisseur e150, supérieure ou égale à une épaisseur e30 de ladite structure, et de préférence telle que e150 ≥ 1.2 * e30.

Ainsi, lorsque la gravure consomme entièrement la couche diélectrique située sur les flancs de la structure, toute la hauteur des flancs de la grille reste recouverte par la couche diélectrique. Par conséquent, le retrait de la couche diélectrique sur les flancs du Fin n'entraîne pas de retrait de cette couche diélectrique sur les flancs de la grille. La couche diélectrique restant sur les flancs de la grille forme les espaceurs du transistor FinFET.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La figure 1 illustre schématiquement un transistor de type FinFET en cours de réalisation, avant gravure des espaceurs.
La figure 2 illustre schématiquement un transistor de type FinFET en cours de réalisation, après gravure des espaceurs.
Les figures 3A à 3J illustrent schématiquement des étapes d'un procédé de gravure selon un mode de réalisation de la présente invention.
La figure 4 est un graphe illustrant l'épaisseur de la couche de protection à base d'oxyde déposée en fonction du temps, pour différentes conditions de plasma à base de SiCl4 et d'oxygène.
La figure 5 est un graphe illustrant la consommation de la couche diélectrique en fonction du temps, pour plasma à base de SiCl4 et d'oxygène selon un mode de réalisation de la présente invention.
La figure 6 est un graphe illustrant la consommation de la couche de protection à base d'oxyde en fonction du temps, pour différentes conditions de plasma à base d'hydrogène.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches et portions, et les dimensions des motifs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, la deuxième gravure est configurée pour modifier une portion supérieure de la couche diélectrique située sur le flanc, par implantation d'espèces à base d'hydrogène. Cela permet de ralentir la formation d'une deuxième couche de protection à base d'oxyde lors d'une première gravure ultérieure. Cela permet d'augmenter la durée d'une première gravure ultérieure. Cela permet d'augmenter l'épaisseur de première couche de protection formée lors d'une première gravure ultérieure. Cela permet de consommer une hauteur de couche diélectrique plus importante lors d'une première gravure ultérieure. Ladite portion supérieure de la couche diélectrique située sur le flanc est également appelée portion latérale modifiée par la suite.

Selon un exemple, la deuxième couche de protection à base d'oxyde est formée sur une portion supérieure de la couche diélectrique située sur le flanc.

Selon un exemple, le plasma à base d'hydrogène de la deuxième gravure comprend des ions parmi H+, H2+, H3+.

Selon un exemple, le plasma de la deuxième gravure est formé à partir de dihydrogène (H2) ou d'ammoniac (NH3) et d'au moins une espèce X favorisant la dissociation du dihydrogène ou de l'ammoniac, ladite au moins une espèce X étant prise parmi l'azote, l'hélium.

Selon un exemple, le plasma à base d'hydrogène de la deuxième gravure est exempt de fluor. Éventuellement, des traces de fluor issu de la première gravure peuvent résider involontairement dans ce plasma à base d'hydrogène de la deuxième gravure. En revanche, lors de la deuxième gravure, aucun composé à base de fluor n'est injecté dans le réacteur. La chimie du plasma de deuxième gravure ne comprend donc pas de composé à base de fluor.

Selon un exemple, le plasma à base d'hydrogène de la deuxième gravure est anisotrope selon la direction (Z) parallèle au flanc de la structure.

Selon un exemple, l'énergie des ions du plasma à base d'hydrogène est inférieure à 250 eV, et de préférence inférieure à 150 eV.

Selon un exemple, le plasma à base d'hydrogène de la deuxième gravure présente une tension de polarisation inférieure à 250 V, et de préférence inférieure à 150 V. Cela permet de limiter voire d'éviter un phénomène de pulvérisation de la première couche de protection à base d'oxyde.

Selon un exemple, le procédé comprend une séquence de première et deuxième gravures initiales et au moins une séquence de première et deuxième gravures ultérieures, et, lors de la répétition de ladite au moins une séquence de première et deuxième gravures ultérieures, la première gravure ultérieure présente une durée supérieure à celle de la première gravure initiale. Cela permet d'augmenter l'épaisseur de première couche de protection formée lors de ladite première gravure ultérieure. Cela permet de consommer une hauteur de couche diélectrique plus importante lors de ladite première gravure ultérieure.

Selon un exemple, la première gravure est configurée de sorte à ce que la première couche de protection à base d'oxyde formée présente une épaisseur e50a supérieure ou égale à 5 nm.

Selon un exemple, la deuxième gravure est configurée de sorte à ce que la portion de la première couche de protection conservée présente une épaisseur e50b supérieure ou égale à 2 nm.

Selon un exemple, le procédé comprend une étape préalable d'oxydation de la couche diélectrique effectuée avant ladite séquence d'étapes, l'étape préalable d'oxydation étant destinée à limiter une gravure latérale de la couche diélectrique lors de la première gravure.

Selon un exemple, le procédé comprend une étape préalable de dépôt de ladite couche diélectrique sur ladite structure. De préférence, le dépôt de ladite couche diélectrique est un dépôt conforme.

Selon un exemple de réalisation, le procédé comprend une étape préalable de gravure de la couche diélectrique, effectuée avant ladite séquence d'étapes, l'étape préalable de gravure étant interrompue de manière à conserver une portion de la couche diélectrique située sur le sommet de la structure, de préférence en un matériau semiconducteur. Cette étape permet typiquement de graver une portion importante de la couche diélectrique. Elle permet d'augmenter la rapidité du procédé.

Selon un exemple de réalisation, l'étape préalable de gravure de la couche diélectrique est basée sur une chimie fluorocarbonée (par exemple CxFy ou CxHyFz).

Dans la suite de la description, on considère que les chimies fluorocarbonées comprennent notamment les composés fluorocarbonés (CxFz) et les composés hydrofluorocarbonés (CxHyFz).

Selon un exemple de réalisation, ledit premier composé à base de fluor (F) de la chimie utilisée pour la première étape de gravure provient, de préférence intégralement, de la chimie utilisée lors de ladite étape préalable de gravure.

Alternativement, une partie au moins et optionnellement tout le premier composé à base de fluor (F) de la chimie utilisée pour la première étape de gravure est fourni durant la première étape de gravure.

Selon un exemple de réalisation, le premier composé à base de fluor (F) provient de la dissociation d'au moins un composé pris parmi les composés fluorocarbonés (par exemple CxFz ou CxHyFz), x, y et z étant des entiers non nuls.

Selon un exemple, les première et deuxième gravures sont effectuées dans un même réacteur.

Selon un exemple, le réacteur est configuré pour former un plasma par couplage capacitif.

Selon un exemple alternatif, le réacteur est configuré pour former un plasma par couplage inductif.

La structure est en un matériau différent de celui de la couche diélectrique. Selon un exemple de réalisation, la structure est en un matériau semi-conducteur. Selon un exemple, la structure forme un canal d'un transistor FinFET.

Selon un exemple de réalisation, le motif de grille comprend une grille et un masque dur surmontant ladite grille.

Selon un exemple, l'épaisseur de masque dur est supérieure ou égale à la hauteur de la structure formant le canal d'un transistor FinFET.

Selon un exemple, le masque dur présente une épaisseur e150, tel que e150 ≥ e30, e30 étant la hauteur de la structure (30), et de préférence e150 ≥ 1.2 * e30.

Selon un exemple de réalisation, le ou les flancs de la structure 3D s'étendent selon un plan perpendiculaire (YZ) à un plan principal (XY) selon lequel le substrat de support s'étend.

Selon un exemple de réalisation, le sommet s'étend principalement dans un plan parallèle au plan (XY) du substrat de support.

Selon un exemple de réalisation, ladite structure 3D est formée par au moins un bloc ou une lamelle de matériau semi-conducteur.

Selon un exemple de réalisation, la couche diélectrique est directement au contact de la structure en un matériau semi-conducteur.

De préférence, le matériau semi-conducteur est du silicium. Le matériau semi-conducteur peut alternativement être du germanium (Ge) ou du silicium-germanium SiGe. La structure en un matériau semi-conducteur peut également être faite d'une succession de couches, chaque couche étant par exemple prise parmi les matériaux suivants: silicium (Si), germanium (Ge), silicium-germanium (SiGe). Ainsi pour la réalisation de nanofils on pourra prévoir une succession de couches formée chacune de Si ou de SiGe.

Selon un exemple, le matériau diélectrique de la couche diélectrique est pris parmi : le SiN, le Si3N4, le SiCO, le SiC, le SiCN, le SiOCN, le SiCBN, le SiOCH.

Selon un exemple de réalisation, lorsque la couche diélectrique située sur le flanc de la structure est entièrement gravée, on effectue ensuite une étape de retrait de la première couche de protection.

De préférence, ce retrait de la première couche de protection est effectué à l'aide d'une solution à base d'acide fluorhydrique (HF).

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants. Ainsi, une couche à base de silicium s'entend par exemple d'une couche Si, Si dopé n, Si dopé p, SiGe. Une couche à base de germanium s'entend par exemple d'une couche Ge, Ge dopé n, Ge dopé p, SiGe.

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 7. Le matériau diélectrique modifié est réputé différent du matériau diélectrique non modifié.

On entend par « nature » d'un matériau, sa composition chimique et/ou sa structure cristalline. Ainsi deux couches peuvent être de même composition chimique mais de nature différente d'un point de vue cristallographique.

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent » se réfèrent à des positions prises selon la direction z.

Les termes « vertical », « verticalement » se réfèrent à une direction selon z. Les termes « horizontal », « horizontalement » se réfèrent à une direction dans le plan xy. Le terme « latéral » se réfère à un plan xz ou yz. Ainsi, les flancs latéraux de la grille s'étendent parallèlement à un plan yz. Les flancs latéraux de la structure Fin s'étendent parallèlement à un plan xz. Sauf mention explicite, l'épaisseur, la hauteur et la profondeur sont mesurées selon z.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Dans le cadre de la présente invention, on désigne par structure en trois dimensions une structure formant une saillie au-dessus d'une couche qui lui est sous-jacente tel un substrat de support.

Dans le cadre de la présente invention, un exemple non limitatif mais particulièrement avantageux de structure 3D est une lamelle (également désignée nageoire ou par son vocable anglais Fin) formant l'extension d'un canal de transistor FinFET, tel qu'illustré à la figure 2. Comme mentionné plus haut, la formation des espaceurs flanquant le motif de grille de ce transistor FinFET requiert une gravure précise des parties de la couche diélectrique recouvrant le Fin.

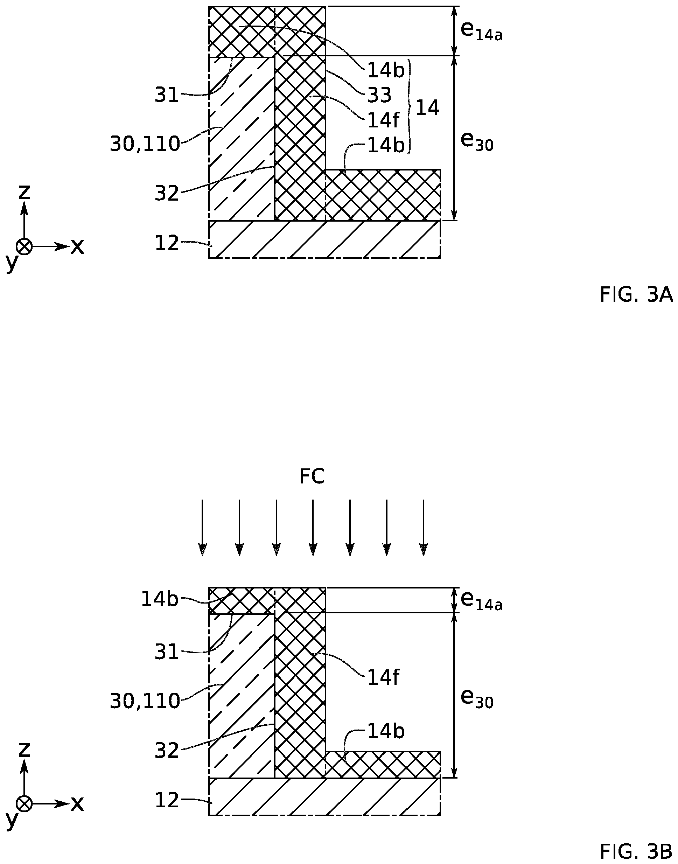

Les figures 3A à 3J illustrent un mode de réalisation du procédé de gravure de la couche diélectrique 14 selon l'invention. Selon ce mode de réalisation non limitatif, une structure initiale sous forme de Fin 30 d'un transistor FinFET est fournie. Par souci de clarté, seul le Fin 30 du transistor FinFET est reproduit sur les figures 3A à 3J, en coupe transverse selon un plan xz. Seul un flanc 32 du Fin 30 est représenté. Les mêmes étapes et caractéristiques s'appliquent aux autres flancs du Fin 30 perpendiculaires au plan basal xy. Il est entendu que ce Fin 30 est de préférence attenant à un motif de grille 13 comprenant de façon connue une grille 130, un masque dur 150 et optionnellement une couche 131 à haute constante diélectrique dite « high k », comme illustré par exemple en figure 1.

Toutes les caractéristiques, étape et avantages techniques qui vont être décrits par la suite s'appliquent également à des modes de réalisation dans lesquels la couche diélectrique 14 surmonte une structure tridimensionnelle différente d'un Fin d'un transistor FinFET. Par exemple ils s'appliquent à des structures formant des nanofils et en particulier des nanofils empilés.

Le Fin 30 est ici supporté par un substrat comprenant typiquement une partie supérieure 12 à base d'oxyde. La hauteur e30 du Fin 30 est référencée sur la figure 3A. Par exemple, la hauteur e30 du Fin, mesurée selon la direction Z depuis la face supérieure 120 de la partie supérieure 12 du substrat, est comprise entre quelques nanomètres et quelques dizaines de nanomètres. Préférentiellement, e30 est compris entre 10 et 200 nanomètres et encore plus préférentiellement, e30 est compris entre 32 et 150 nm et encore plus préférentiellement.

La partie supérieure 12 du substrat peut typiquement correspondre à une couche d'oxyde enterré BOX provenant d'un substrat de type silicium sur isolant SOI. D'autres substrats, par exemple en matériau semiconducteur massif, peuvent alternativement être utilisés. En particulier, la partie supérieure 12 n'est pas nécessairement à base d'oxyde.

Le Fin 30 et la partie supérieure 12 du substrat sont recouverts par une couche diélectrique 14 comprenant des portions basales 14b et une ou plusieurs portions latérales 14f. Les portions basales 14b recouvrent le sommet 31 du Fin 30 et la face supérieure 120 de la partie supérieure 12 du substrat. La portion latérale 14f recouvre le flanc 32 du Fin 30.

De préférence, cette couche diélectrique 14 est une couche conforme.

Dans cet exemple lié aux transistors FinFET, cette couche diélectrique 14 est destinée à former des espaceurs sur les flancs de la grille 130. Cette couche diélectrique 14 est alors formée dans des matériaux présentant une faible constante diélectrique. Cette couche diélectrique 14 peut être poreuse ou non. Elle est par exemple formée dans l'un des matériaux suivants : SiCO, SiC, SiCN, SiOCN ou SiCBN, ou un nitrure de silicium (SixNy, x et y étant des entiers), typiquement du SiN.

Une fois déposée, cette couche diélectrique 14 présente par exemple une épaisseur e14a comprises entre 4 et 50 nanomètres, de préférence entre 4 et 30 nanomètres et de préférence entre 8 et 12 nanomètres. L'épaisseur e14a est mesurée selon la direction Z. Elle est référencée en figure 3A.

Cette couche diélectrique 14 est par exemple formée par l'une des techniques suivantes : dépôt chimique en phase vapeur assisté par plasma (PECVD, acronyme de plasma enhanced chemical vapor déposition), dépôt chimique en phase vapeur à basse pression (LPCVD, acronyme de low pressure CVD), dépôt par couche atomique assistée par plasma (PEALD, acronyme de plasma enhanced atomic layer déposition).

À partir de la structure illustrée en figure 3A plusieurs étapes vont être mises en oeuvre dans le but de retirer entièrement la couche diélectrique 14 sur le sommet 31 et sur les flancs 32 du Fin 30, sans laisser de résidus de couche diélectrique et sans endommager le Fin 30 et la partie supérieure 20 du substrat.

La figure 3B illustre une étape optionnelle au cours de laquelle une partie seulement de l'épaisseur de la couche diélectrique 14 est retirée sur les zones parallèles au plan XY du substrat 10. Cette étape de retrait comprend principalement une gravure anisotrope dirigée selon z. Cette gravure anisotrope permet d'augmenter la rapidité du procédé avant les étapes ultérieures qui vont permettre une gravure très précise.

Typiquement, au cours de cette étape préalable de gravure, plus de 70 % et de préférence plus de 80 % et encore plus préférentiellement plus de 90 % de l'épaisseur initiale e14a de la couche diélectrique 14 est gravée.

Typiquement, à l'issue de la gravure, la couche diélectrique 14 présente une épaisseur résiduelle e14b supérieure à 2 nm, de préférence supérieure à 3 nm et de préférence supérieure à 4 nm. Typiquement, l'épaisseur e14b résiduelle est comprise entre 2 et 3 nm, de façon à éviter un endommagement des couches sous-jacentes lors de cette gravure préalable.

Cette étape de gravure est par exemple effectuée dans un équipement de gravure de type réacteur plasma à couplage inductif (ICP), ou réacteur plasma à couplage capacitif (CCP).

Cette étape de gravure par plasma est basée sur une chimie comprenant un composé à base de fluor (F). De préférence, cette chimie comprend une espèce fluorocarbonée, par exemple pris parmi les espèces suivants CxHyFz ou CxHy, x, y et z étant des entiers. Cette chimie de gravure a pour avantage d'améliorer l'anisotropie de la gravure. Cette anisotropie permet de ne pas graver les surfaces qui sont parallèles à la direction privilégiée de gravure. Dans le cas d'un transistor FinFET, l'anisotropie de la gravure permet de ne pas graver les portions 14g de couche diélectrique 14 situées sur les flancs de la grille 130 et destinée à former les espaceurs 140 du transistor. Le contrôle dimensionnel, selon y, de ces espaceurs 140 impactant directement les performances du transistor, il est important de ne pas graver involontairement la couche diélectrique 14 sur les flancs de la grille 130.

De préférence, la chimie fluorocarbonée comprend également au moins une espèce additionnelle de dilution ou de dissociation telle que l'argon (Ar), l'hélium (He), l'azote (N) ou l'oxygène (O). Le plasma peut être continu ou pulsé.

Selon un exemple, les conditions de cette gravure préalable sont les suivantes : le plasma est formé à partir de CHF3 présentant un débit de 30 sccm, et à partir d'hélium présentant un débit de 220 sccm. La puissance de la source est de 300 W et la tension de polarisation (bias) est de 65 V. La pression est de 5 milliTorr. La température du substrat de support est de 60°C. Le temps de gravure est de 20s. Cela permet typiquement de graver environ 6 nm de SiN.

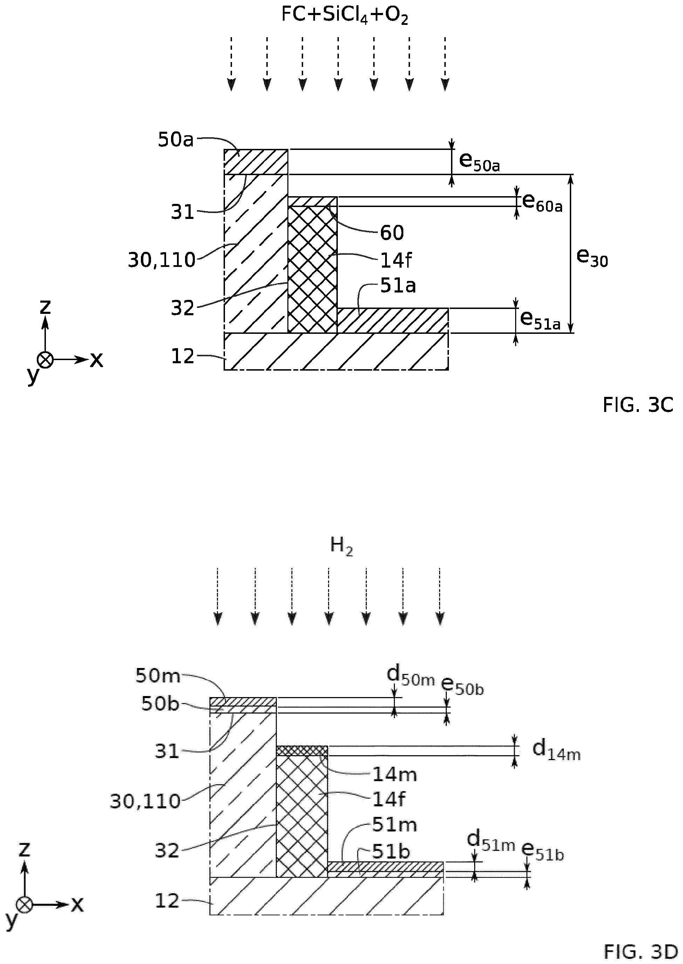

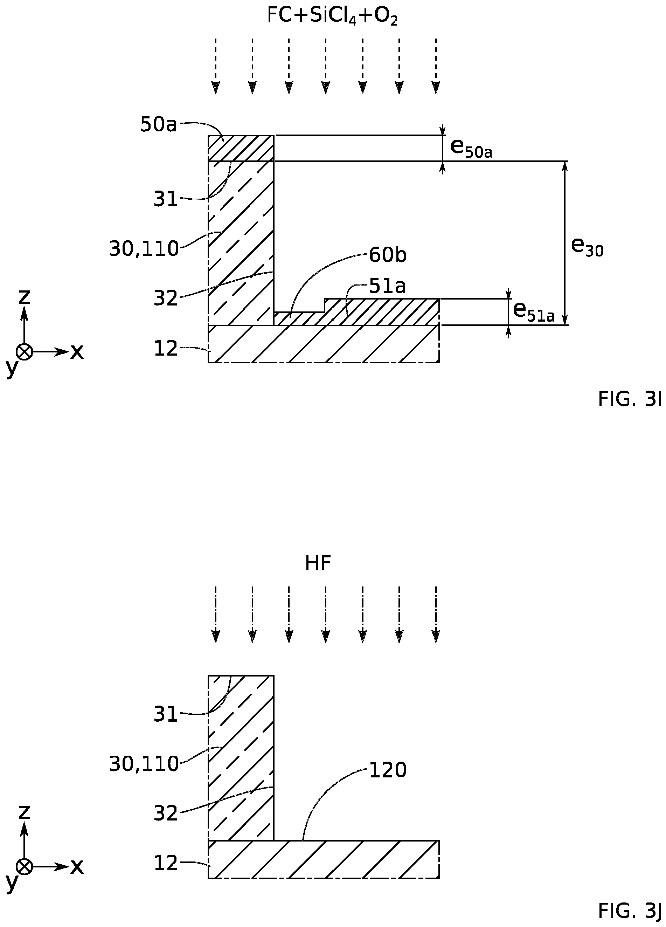

Les figures 3C à 3I illustrent différentes étapes d'une séquence d'étapes qui peut être réitérée jusqu'à obtenir le résultat qui est illustré en figure 3I.

Comme illustré en figure 3C, à l'issue de la gravure préalable, ou après le dépôt de la couche diélectrique 14 (dans le cas où il n'y a pas de gravure préalable), on effectue une première gravure de la couche diélectrique 14.

Cette première gravure est configurée de manière à graver le matériau de la couche diélectrique 14 préférentiellement au matériau de la structure en un matériau semi-conducteur 30.

Par ailleurs, cette gravure est configurée de manière à:
- s'interrompre avant de consommer toute la hauteur selon z de la portion latérale 14f de la couche diélectrique, située sur le flanc 32 de la structure 30 ;
- former une première couche de protection 50a sur le sommet 31 de la structure 30 en un matériau semi-conducteur et à former une deuxième couche de protection 60 sur une partie supérieure de la portion latérale 14f de la couche diélectrique située sur le flanc 32, l'épaisseur e50a de la première couche de protection 50a étant supérieure à l'épaisseur e60a la deuxième couche de protection 60.

Cette première gravure est de préférence une gravure plasma. Cette première gravure de la couche diélectrique 14 utilise une chimie comprenant :
- au moins un premier composé à base de fluor (F) et
- au moins un deuxième composé pris parmi le SiwCI(2w+2) et le SiwF(2w+2) w étant un entier,
- de l'oxygène (O).

Le premier composé à base de fluor permet une gravure efficace de la couche diélectrique 14 avec une bonne anisotropie.

Le deuxième composé permet d'améliorer la sélectivité de la gravure de la couche diélectrique vis-à-vis des couches sous-jacentes, par exemple faite d'un matériau semi-conducteur ou d'oxyde de silicium (SiO2).

La quantité du premier composé à base de fluor est régulée de manière à consommer tous les composés à base de fluor, et donc à interrompre la première gravure avant de consommer toute l'épaisseur (prise selon l'axe Z) de la portion latérale 14f de couche diélectrique 14 qui est située sur le flanc 32.

Selon un mode de réalisation particulièrement avantageux, le premier composé à base de fluor a été intégralement introduit lors de l'étape préalable de gravure illustrée en figure 3B. Le fluor subsistant à l'issue de cette étape préalable de gravure est utilisé lors de ladite première gravure jusqu'à être entièrement consommé.

Alternativement, une partie ou l'intégralité des composés à base de fluor consommé lors de cette première gravure est introduite dans le réacteur plasma durant cette première gravure.

La présence d'oxygène dans la chimie du plasma permet de former un oxyde à la surface des couches mises à nu. Tant qu'il y a des composés permettant la gravure des couches, typiquement le composé à base de fluor, la gravure ne permet pas la formation d'une couche d'oxyde. En revanche, une fois que les composés permettant la gravure ont été entièrement consommés, une ou des couches d'oxyde se forment sur les surfaces mises à nu. Ces couches d'oxyde croissent ou se déposent principalement selon z, selon la direction privilégiée de bombardement des ions issus du plasma. La composition et/ou l'épaisseur de ces couches d'oxyde peuvent varier en fonction de la nature des surfaces sur laquelle elles se forment. Ces couches d'oxyde sont typiquement à base de SiOx.

Ainsi, une couche d'oxyde également appelée première couche de protection 50a se forme sur le sommet 31 de la structure 30. Cette première couche de protection 50 est par exemple de type SixOyFz, si la structure 30 est à base de silicium.

Une couche d'oxyde également appelée deuxième couche de protection 60 se forme sur la partie supérieure de la portion latérale 14f de couche diélectrique située sur le flanc 32 du Fin 30. Cette deuxième couche de protection 60 est par exemple de type SixOyNwFz, si la couche diélectrique 40 est à base de SiN.

Une couche d'oxyde également appelée troisième couche de protection 51a se forme sur la face supérieure 120 de la partie supérieure 12 du substrat. Cette troisième couche de protection 51a est par exemple de type SixOyFz, si la partie supérieure 12 du substrat est une couche isolante à base de SixOy.

La formation de la première couche de protection 50a au sommet 31 du Fin est privilégiée du fait de la nature du Fin, typiquement en silicium.

Il s'ensuit que l'épaisseur e50a de la couche de protection 50 formée sur le sommet 31 de la structure 30 est supérieure à l'épaisseur e60a formée sur la portion latérale 14f située sur le flanc 32 de cette structure 30.

Ainsi, la première couche de protection 50a présente une épaisseur e50a supérieure à celle e60a de la deuxième couche de protection 60. Typiquement, e50a ≥k1.e60a, avec k1=1.5 et de préférence k1=2 et de et de préférence k1=3.

De manière avantageuse, la couche de protection 51a formée sur la surface de la couche isolante 12 présente une épaisseur e51a supérieure à celle e60a de la couche de protection 60 située sur la portion latérale 14f. Typiquement, e51a ≥. k2.e60a, avec k2=1.5 et de préférence k2=2 et de préférence k2=3.

De préférence, la chimie utilisée pour cette première gravure comprend également des espèces de dilution ou de dissociation telle que l'argon, l'hélium ou l'azote. Le plasma peut être continu ou pulsé. De manière générale, un plasma pulsé permet de limiter l'endommagement du matériau semi-conducteur de la structure 30. La fréquence du plasma pulsé est de préférence comprise entre 200 Hz et 5 kHz, de préférence de l'ordre de 500 Hz, avec un taux d'activation de 10% à 90% et typiquement de 50%.

Par exemple, au cours de cette première gravure, on utilise pour le plasma une chimie comprenant :
- du CxHyFz, par exemple du CH3F,
- du SiCl4 dont le débit est compris entre 2 et 10 sccm et de préférence entre 2 et 5 sccm,
- de l'oxygène,
- éventuellement un gaz de dissociation telle que l'Ar, l'He ou le N2.

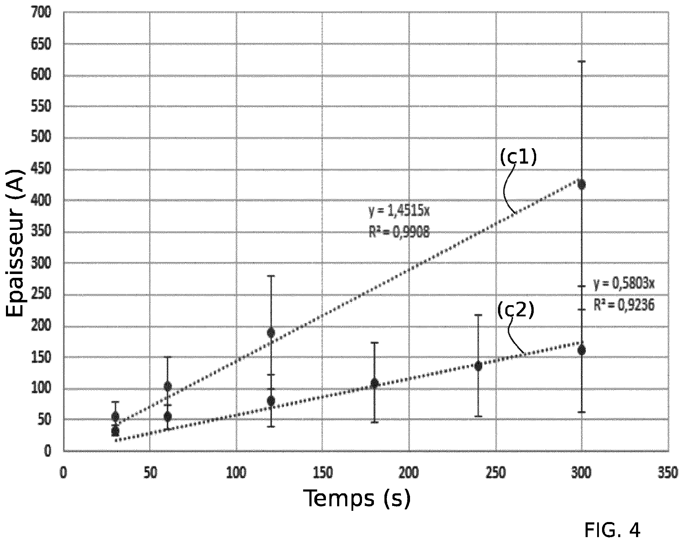

La figure 4 illustre l'épaisseur de dépôt de première couche de protection en fonction du temps, pour différentes teneurs en SiCl4 dans le plasma. Pour un débit en SiCl4 de 5 sccm, il est ainsi possible de déposer environ 18 nm d'oxyde sur du silicium polycristallin en 2 min, comme illustré par la courbe (c1). La vitesse de dépôt d'oxyde est ici de 8,71nm/min.

Pour un débit en SiCl4 de 2 sccm, il est ainsi possible de déposer environ 7 nm d'oxyde sur du silicium polycristallin en 2 min, comme illustré par la courbe (c2). La vitesse de dépôt d'oxyde est ici de 3,48nm/min.

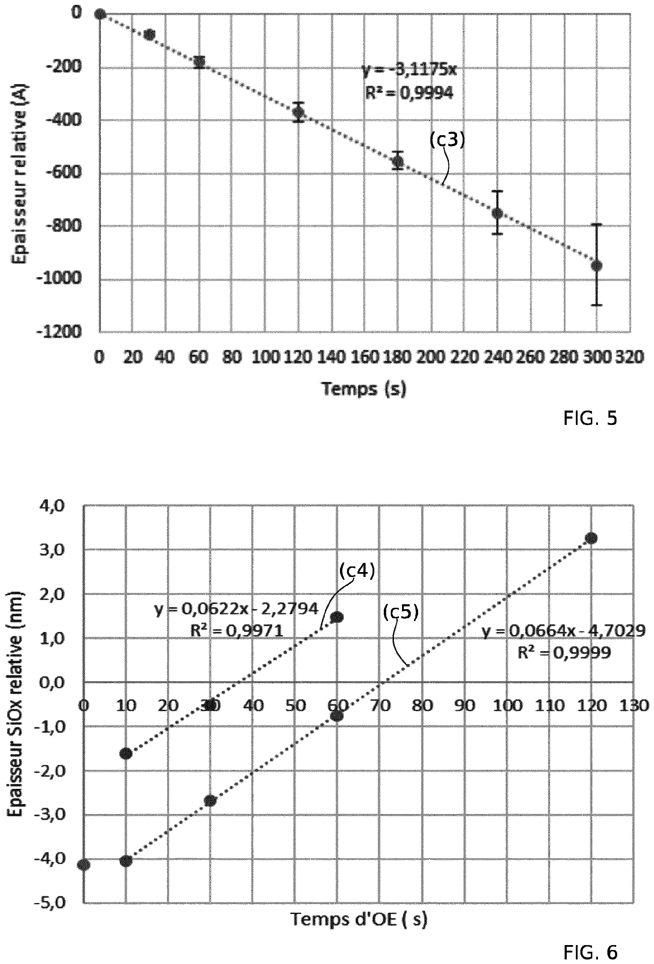

La figure 5 illustre la consommation de la couche diélectrique 14 en fonction du temps. Pour un débit en SiCl4 de 2 sccm, il est ainsi possible de consommer environ 40 nm de Si3N4 en 2 min, comme illustré par la courbe (c3).

Selon un exemple, les conditions de la première gravure sont les suivantes : le plasma est formé à partir d'un mélange de CH3F présentant un débit de 200 sccm, d'hélium présentant un débit de 120 sccm, de SiCl4 présentant un débit de 2 sccm, et d'oxygène présentant un débit de 200 sccm. La puissance de la source est de 400 W et la tension de polarisation (bias) est de 250 V. La pression est de 90 milliTorr. La température du substrat de support est de 60°C. Le temps de gravure est de 30s. Cela permet de former une première couche de protection de 4 à 5 nm d'épaisseur sur le sommet du Fin tout en ayant consommé 5 à 7 nm de SiN de la portion latérale de couche diélectrique.

Typiquement, au-delà d'une durée de 30 à 35 secondes, la portion latérale 14f de couche diélectrique SiN n'est plus gravée et la deuxième couche de protection 60 en oxyde commence à se déposer sur le SiN. On peut en déduire que les espèces participant activement à la gravure, telle que le composé à base de fluor (F), ne sont plus présents en quantité suffisante au-delà de cette durée. Au bout de cette durée, on peut donc interrompre la première gravure, puis mettre en oeuvre la deuxième gravure.

L'homme du métier saura déterminer des conditions de fonctionnement adaptées aux matériaux et aux épaisseurs de son application. Ainsi, il saura déterminer la teneur en SixCly ou SixFy dans le mélange ainsi que le temps de gravure.

Comme illustré en figure 3D, à l'issue de la première gravure, on effectue une deuxième gravure.

Les première et deuxième gravures, et optionnellement la gravure préalable, sont de préférence effectuée dans un même équipement de gravure, par exemple de type réacteur plasma à couplage inductif (ICP), ou réacteur plasma à couplage capacitif (CCP). Les première et deuxième gravures peuvent ainsi être réalisées de façon cyclique *in situ* dans le même réacteur.

La première gravure peut être prolongée au début de la deuxième gravure, pendant un temps dit de surgravure, ou « overetch (OE) » selon la terminologie courante.

La deuxième gravure vise à retirer entièrement la deuxième couche de protection 60 située sur la partie supérieure de la portion latérale 14f de couche diélectrique recouvrant le flanc 32 tout en conservant une portion 50b d'épaisseur e50b de la première couche de protection sur le sommet 31 du Fin 30.

Cet objectif est d'autant plus facilement atteint que l'épaisseur e50a de la première couche de protection 50a est plus épaisse que l'épaisseur e60a de la deuxième couche de protection 60.

Par ailleurs, au cours de cette étape, on conserve également une portion 51b d'épaisseur e51b de la troisième couche de protection formée au-dessus de la couche isolante 12.

La deuxième gravure peut également consommer faiblement le matériau diélectrique de la portion latérale 14f, après retrait de la deuxième couche de protection 60. Cette consommation est néanmoins moins importante que lors de la première gravure. Ce n'est pas l'objectif principal de cette deuxième gravure.

Cette deuxième gravure vise également à modifier le matériau diélectrique de la portion latérale 14f. Ainsi, les espèces implantées lors de cette deuxième gravure modifient typiquement une portion 14m de la portion latérale 14f, sur une profondeur d14m comprise entre quelques nanomètres et quelques dizaines de nanomètres, typiquement entre 5 nm et 10 nm. Cette modification du matériau diélectrique permet avantageusement, lors de la répétition de la première gravure dans une séquence suivante, de ralentir la formation de la deuxième couche de protection. Le blocage de gravure due à la formation de cette deuxième couche de protection survient alors plus tardivement. La gravure de la couche diélectrique modifiée est alors plus efficace. En particulier, la nouvelle première gravure qui suit cette deuxième gravure peut durer plus longtemps. L'épaisseur des première et/ou troisième couches de protection à base d'oxyde formées lors de cette nouvelle première gravure est alors plus importante. La protection du sommet du Fin et/ou de la couche isolante est ainsi améliorée. Ainsi, la deuxième gravure améliore significativement les effets de la première gravure qui lui succède, dite première gravure ultérieure, en comparaison de la première gravure initiale. La deuxième gravure permet à la première gravure ultérieure de former une des couches de protection plus épaisses sur le sommet du Fin et/ou sur la couche isolante tout en consommant une hauteur de portion latérale de couche diélectrique plus importante.

Les espèces implantées lors de cette deuxième gravure peuvent également modifier une portion 50m de la première couche de protection, sur une profondeur d50m de l'ordre de quelques nanomètres. Les espèces implantées lors de cette deuxième gravure peuvent également modifier une portion 51m de la troisième couche de protection, sur une profondeur d51m de l'ordre de quelques nanomètres.

La deuxième gravure est anisotrope, dirigée principalement selon z. Elle est effectuée par plasma à partir d'une chimie comprenant une source d'hydrogène, par exemple H2 ou NH3. De préférence, cette chimie de plasma comprend également au moins une espèce additionnelle de dilution ou de dissociation telle que l'hélium (He) ou l'azote (N). Le gaz de dissociation est typiquement inerte chimiquement vis-à-vis du matériau diélectrique, de façon à éviter une consommation trop importante de matériau diélectrique lors de cette deuxième gravure. Le débit de H2 ou de NH3 peut être compris entre 10 et 200 sccm. Le débit du gaz de dissociation peut être compris entre 0 et 500 sccm. Le plasma peut être continu ou pulsé fréquence du plasma pulsé selon une fréquence de préférence comprise entre 200 Hz et 5 kHz, avec un taux d'activation de 10% à 90%. Un tel plasma pulsé permet de diminuer l'énergie des ions à base d'hydrogène. La pression dans le réacteur peut être comprise entre 5 milliTorr et 100 milliTorr. La puissance de la source plasma peut être comprise entre 0 et 2000 W. La tension de polarisation (bias) peut être comprise entre 20 V et 500 V. La température du substrat de support peut être comprise entre 10°C et 100°C. Le temps de gravure de cette deuxième gravure peut être de l'ordre de quelques secondes à quelques centaines de secondes. Ces conditions peuvent être adaptées en fonction des applications visées et de la hauteur de matériau diélectrique à graver.

La figure 6 illustre une épaisseur de SiO2 pulvérisé en fonction du temps, pour différentes tensions de polarisation du plasma H2. Les courbes (c4) et (c5) sont ici tracées respectivement pour une tension de polarisation de 150V et de 250V, dans des conditions d'overetch de 2sccm de débit de SiCl4. Il apparaît qu'une tension de polarisation de 250V du plasma H2 (avec ou sans overetch) peut entraîner une pulvérisation d'oxyde sur une profondeur de 4 nm. Pour limiter ce phénomène de pulvérisation, on préférera choisir une tension de polarisation inférieure à 250V, et de préférence inférieure à 150 V.

Selon un exemple, les conditions de la deuxième gravure sont les suivantes : le plasma est formé à partir de H2 présentant un débit de 100 sccm. La puissance de la source est de 500 W et la tension de polarisation (bias) est inférieure à 150 V, par exemple 100 V. La pression est de 10 milliTorr. La température du substrat de support est de 60°C. Le temps de gravure est de 30s.

Cette deuxième étape de gravure est interrompue, par exemple au temps, avant que toute la première couche de protection 50b soit consommée.

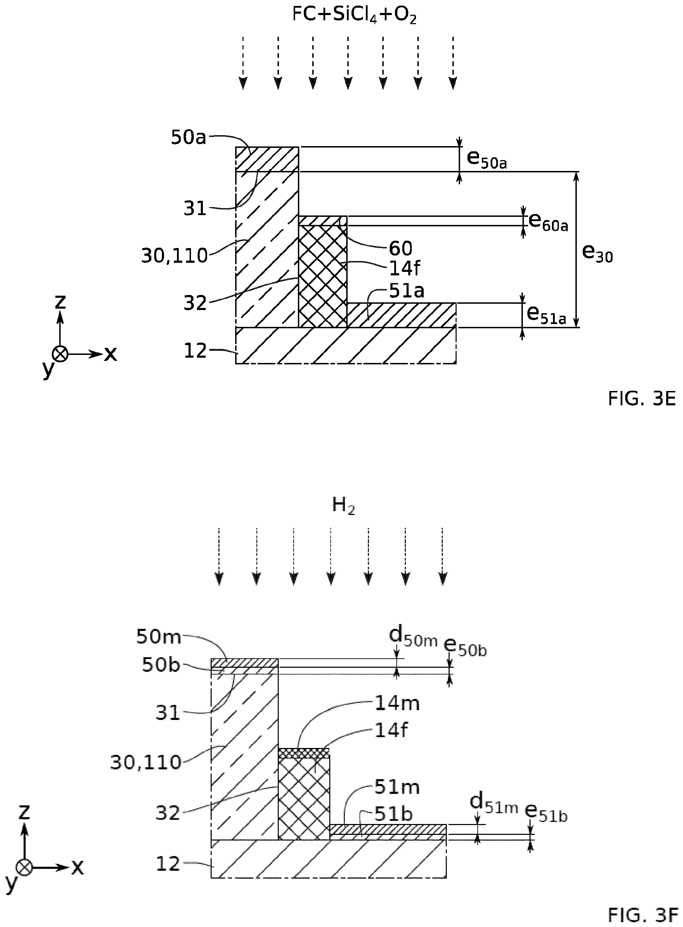

Comme illustré aux figures 3E, 3F, puis 3G, 3H, les première et deuxième gravures sont répétées alternativement.

Selon un principe de l'invention, la deuxième gravure augmente l'efficacité de la première gravure qui lui succède, dans la séquence d'étapes de première et deuxième gravures. En particulier, la vitesse de gravure du SiN modifié par implantation d'hydrogène est supérieure à la vitesse de gravure du SiN non modifié, dans les conditions de gravure de la première gravure. La formation de la deuxième couche de protection sur le SiN modifié est en outre retardée lors de la première gravure. Cela permet d'augmenter la durée de la première gravure avant que ne survienne un blocage de gravure dû à ladite deuxième couche de protection. La formation de la première couche de protection sur le SiOx modifié est par ailleurs favorisée lors de la première gravure. Cela permet d'augmenter l'épaisseur de la première couche de protection.

Le SiN de la portion latérale de couche diélectrique sur le flanc du Fin peut ainsi être gravé plus rapidement tout en améliorant la protection du sommet du Fin.

Tout au long de chaque séquence, le sommet 31 du Fin 30 reste protégé par la première couche de protection 50a, 50b formée lors de la première étape de gravure de chaque séquence. Il en est de même pour la face supérieure 120 de la couche isolante 12 qui reste protégée par la couche de protection 60a, 60b. Au cours de chaque première gravure, la portion latérale 14f de couche diélectrique 14 recouvrant le flanc 32 du Fin 30 a quant à elle été fortement consommée.
Comme illustré en figure 3E, à l'issue de la deuxième gravure, on effectue une nouvelle première gravure. On voit sur cette figure 3E que la hauteur e30 du Fin 30 n'a pas été consommée et que le sommet 31 du Fin 30 est toujours recouvert par une couche de protection 50a. La portion latérale 14f de couche diélectrique 14 recouvrant le flanc 32 du Fin 30 a quant à elle été significativement consommée.
Comme illustré en figure 3F, à l'issue de la nouvelle première gravure, on effectue une nouvelle deuxième gravure. On voit sur cette figure 3F que le sommet 31 du Fin 30 est toujours recouvert par une couche de protection 50b, tandis que la deuxième couche de protection 60 a été retirée sur la portion latérale 14f. Une portion 14m de portion latérale 14f a en outre été modifiée par implantation d'espèces à base d'hydrogène.

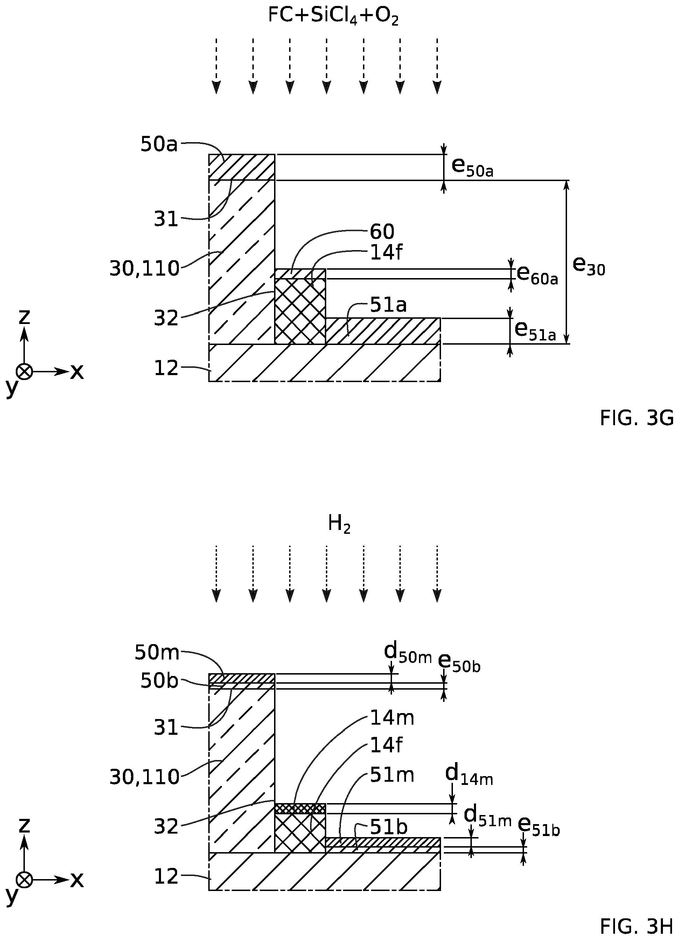

Comme illustré aux figures 3G, 3H des séquences additionnelles de première et deuxième gravures peuvent être effectuées de façon à consommer toute la hauteur de portion latérale 14f.

La figure 3I illustre le résultat que l'on obtient lorsque la gravure du SiN est arrêtée à l'issue d'une première étape de gravure après avoir réitéré la séquence d'étapes. Comme illustré, la portion 14f de couche diélectrique 14 recouvrant le flanc 32 du Fin 30 est entièrement consommée. En revanche, la hauteur e30 du Fin 30 n'a pas été consommée. Le sommet 31 du Fin 30 est toujours recouvert par une couche de protection d'oxyde 50a. La face supérieure 120 de la couche isolante 12 peut être recouverte par une couche de protection d'oxyde 60b, 51a, qui n'est pas nécessairement uniforme en épaisseur.

On peut ensuite retirer les couches de protection 50a, 51a, 50b, 51b, 60b. Pour cela on pourra par exemple procéder à un retrait par voie humide, par exemple en utilisant un bain HF (acide fluorhydrique). Selon les cas, il est possible que l'on ait une légère consommation de la couche isolante 12. De façon générale, les couches de protection à base d'oxyde formées sont peu denses et se graveront plus vite que l'oxyde de type BOX de la couche isolante. Les couches de protection à base d'oxyde modifié se gravent avantageusement beaucoup plus vite que l'oxyde de type BOX. Ainsi, la consommation de l'oxyde de type BOX de la couche isolante reste très faible, voire inexistante.

La figure 3J illustre le résultat obtenu après retrait des couches de protection. La portion 14f de couche diélectrique 14 recouvrant le flanc 32 du Fin 30 a été entièrement consommée, tandis que la hauteur e30 du Fin 30 n'a pas été consommée.

Optionnellement, avant gravure de la couche diélectrique 14, c'est-à-dire avant l'étape préalable si elle est effectuée ou avant la première séquence comprenant les première et deuxième gravures, on peut effectuer une étape de protection des flancs 33 de la couche diélectrique 14 (figure 3A). En effet, au cours des différentes gravures, on cherche à graver la couche diélectrique 14 selon une direction Z perpendiculaire au plan XY du substrat 10. Ainsi, il peut être avantageux de limiter la consommation latérale (selon l'axe X) de la couche diélectrique 14. Pour cela, on peut former, de préférence par oxydation, une couche de protection latérale sur la couche diélectrique 14.

Dans le cas de la réalisation d'un transistor FinFET, on souhaite conserver la portion 14g de couche diélectrique 14 sur les flancs de la grille 130 tout en retirant entièrement les portions 14b, 14f de couche diélectrique 14 sur les Fins 30 (figures 1, 2). Or, les flancs de la grille 130 et les flancs 32 du Fin 30 sont généralement perpendiculaires au plan principal XY du substrat de support 10 et sont généralement parallèles à la direction principale Z d'implantation des ions issus du plasma. Afin d'éviter de consommer la couche diélectrique sur les flancs de la grille 130 lors du retrait de cette même couche sur les flancs des Fins 30, on prévoit que l'épaisseur e150 du masque dur 150 surmontant la grille 130 soit supérieure ou égale à l'épaisseur e30 du Fin 30. Ainsi, lorsque les portions latérales 14f de couche diélectrique 14 recouvrant les flancs 32 du Fin 30 seront entièrement consommées, la couche diélectrique 14 aura été consommée sur une partie au moins de l'épaisseur du masque dur 150 mais continuera de recouvrir intégralement les flancs de la grille 130.

Au vu de la description qui précède, il apparaît clairement que la présente invention propose une solution efficace pour graver entièrement et avec une grande précision la couche diélectrique sur le sommet et les flancs d'une structure 3D tout en évitant d'endommager cette structure 3D. Typiquement, la gravure de la couche diélectrique se fait avec une précision atomique ou proche de la monocouche gravée.

L'invention n'est pas limitée aux modes de réalisation précédemment décrits.

Par exemple, le procédé peut ne pas comprendre d'étape préalable de gravure. Ainsi, la gravure de la couche diélectrique est uniquement opérée par les séquences comprenant les première et deuxième gravures.

Bien qu'elle trouve pour application particulièrement avantageuse la réalisation des transistors de type FinFET, l'invention s'applique à toutes les gravures d'une couche diélectrique sur une structure en trois dimensions. Ainsi, elle trouvera pour application la réalisation de transistors à base de nanofils, en particulier à base de nanofils empilés.

## Revendications

1. Procédé de gravure d'une couche diélectrique (14) recouvrant au moins un sommet (31) et un flanc (32) d'une structure (30) tridimensionnelle, ledit procédé comprenant une pluralité de séquences comprenant chacune au moins les étapes successives suivantes :
- une première gravure de la couche diélectrique (14), par plasma, en utilisant une chimie comprenant :
∘ au moins un premier composé à base de fluor (F) provenant de la dissociation d'au moins un composé pris parmi les composés fluorocarbonés CxFz ou CxHyFz, x, y et z étant des entiers non nuls, et
∘ au moins un deuxième composé pris parmi le SiwCI(2w+2) et le SiwF(2w+2) w étant un entier non nul,
∘ de l'oxygène (O),
ladite première gravure étant effectuée de manière à :
∘ générer un bombardement ionique dirigé principalement selon une direction (Z) parallèle audit flanc (32),
∘ réguler la quantité de l'au moins un premier composé pour consommer tout ledit premier composé à base de fluor lors de cette première gravure de manière à interrompre la première gravure avant consommation de toute l'épaisseur de la couche diélectrique (14, 14f) située sur le flanc (32) et après avoir consommé toute l'épaisseur de la couche diélectrique (14, 14b) située sur le sommet (31),
∘ former une première couche de protection (50a) à base d'oxyde sur le sommet (31) de la structure (30) tridimensionnelle et former une deuxième couche de protection (60) à base d'oxyde sur la couche diélectrique (14, 14f) située sur le flanc (32), une épaisseur e50a de la première couche de protection (50a) étant supérieure à une épaisseur e60a de la deuxième couche de protection (60),
- une deuxième gravure configurée pour retirer entièrement la deuxième couche de protection (60) tout en conservant une portion (50b) d'épaisseur e50b de la première couche de protection (50a, 50b, 50m), ladite séquence de première et deuxième gravures étant répétée jusqu'au retrait complet de la couche diélectrique (14, 14f) située sur le flanc (32) de la structure (30) tridimensionnelle, ledit procédé étant **caractérisé en ce que** la deuxième gravure est effectuée par plasma à base d'hydrogène. , comme du dihydrogène (H2) ou de l'ammoniac (NH3).

2. Procédé selon la revendication précédente dans lequel la deuxième gravure est configurée pour modifier une portion supérieure (14m) de la couche diélectrique (14, 14f) située sur le flanc (32), par implantation d'espèces à base d'hydrogène.

3. Procédé selon l'une quelconque des revendications précédentes dans lequel le plasma à base d'hydrogène de la deuxième gravure est exempt de fluor.

4. Procédé selon l'une quelconque des revendications précédentes dans lequel le plasma de la deuxième gravure est formé à partir de dihydrogène (H2) ou d'ammoniac (NH3) et d'au moins une espèce X favorisant la dissociation du dihydrogène ou de l'ammoniac, ladite au moins une espèce X étant prise parmi l'azote, l'hélium.

5. Procédé selon l'une quelconque des revendications précédentes, dans lequel le plasma à base d'hydrogène de la deuxième gravure est anisotrope selon la direction (Z) parallèle au flanc (32) de la structure (30).

6. Procédé selon l'une quelconque des revendications précédentes, dans lequel le plasma à base d'hydrogène de la deuxième gravure présente une tension de polarisation inférieure à 250 V, et de préférence inférieure à 150 V.

7. Procédé selon l'une quelconque des revendications précédentes, comprenant une séquence de première et deuxième gravures initiales, et dans lequel, lors de la répétition d'une séquence de première et deuxième gravures ultérieures, la première gravure ultérieure présente une durée supérieure à celle de la première gravure initiale.

8. Procédé selon l'une quelconque des revendications précédentes, dans lequel la première gravure est configurée de sorte à ce que la première couche de protection (50a) à base d'oxyde formée, présente une épaisseur e50a supérieure ou égale à 5 nm.

9. Procédé selon l'une quelconque des revendications précédentes, dans lequel la deuxième gravure est configurée de sorte à ce que la portion de la première couche de protection (50b) conservée, présente une épaisseur e50b supérieure ou égale à 2 nm.

10. Procédé selon l'une quelconque des revendications précédentes, comprenant une étape préalable de gravure de la couche diélectrique (14), effectuée avant ladite séquence d'étapes, l'étape préalable de gravure étant interrompue de manière à conserver une portion de la couche diélectrique (14, 14b) située sur le sommet (31) de la structure (30) tridimensionnelle.

11. Procédé selon l'une quelconque des revendications précédentes, dans lequel la deuxième couche de protection (60) à base d'oxyde est formée sur une portion supérieure de la couche diélectrique (14, 14f) située sur le flanc (32).

12. Procédé selon l'une quelconque des revendications précédentes comprenant une étape préalable d'oxydation de la couche diélectrique (14), effectuée avant ladite séquence d'étapes, l'étape préalable d'oxydation étant destinée à limiter une gravure latérale de la couche diélectrique (14, 14g) lors de la première gravure.

13. Procédé selon l'une quelconque des revendications précédentes dans lequel la structure (30) est en un matériau semi-conducteur et forme un canal (110) d'un transistor FinFET.

14. Procédé de réalisation d'un transistor FinFET (100) surmontant un substrat de support (10), le transistor FinFET (100) comprenant une grille (130) et au moins un canal (110) traversant la grille (130) et s'étendant depuis un flanc de la grille (130) pour former au moins une structure (30) en un matériau semi-conducteur,
ladite structure (30) présentant un sommet (31) et au moins deux flancs (32), le procédé comprenant :
- le dépôt d'une couche diélectrique (14) recouvrant la grille (130) et ladite structure (30),
- la gravure de la couche diélectrique (14) en mettant en oeuvre le procédé selon l'une quelconque des revendications précédentes, de manière à retirer complètement la couche diélectrique (14, 14f, 14b) située sur la structure (30) formée par le canal (110).

15. Procédé selon la revendication précédente dans lequel le transistor (100) présente un masque dur (150) recouvrant un sommet de la grille (130), la couche diélectrique (14, 14b) étant déposée sur le masque dur (150), le masque dur (150) présentant une épaisseur e150, tel que e150 ≥ e30, e30 étant la hauteur de la structure (30), et de préférence e150 ≥ 1.2 * e30.

## Patentansprüche

1. Verfahren zum Ätzen einer dielektrischen Schicht (14), die mindestens eine Oberseite (31) und eine Flanke (32) einer dreidimensionalen Struktur (30) bedeckt, wobei das Verfahren eine Mehrzahl von Abläufen umfasst, von denen jeder mindestens die folgenden aufeinanderfolgenden Schritte umfasst:
- ein erstes Ätzen der dielektrischen Schicht (14) durch Plasma unter Verwendung einer Chemie, die Folgendes umfasst:
o mindestens eine erste Verbindung auf Fluorbasis (F), die aus der Dissoziation mindestens einer Verbindung stammt, die aus den Fluorkohlenstoffverbindungen CxFz oder CxHyFz stammt, wobei x, y und z ganze Zahlen ungleich Null sind, und
o mindestens eine zweite Verbindung aus SiwCl(2w+2) und SiwF(2w+2), wobei w eine ganze Zahl ungleich Null ist,
o Sauerstoff (0),
wobei das erste Ätzen so durchgeführt wird, dass:
o ein Ionenbeschuss erzeugt wird, der im Wesentlichen in eine Richtung (Z) parallel zu der Flanke (32) gerichtet ist,
o die Menge mindestens einer ersten Verbindung reguliert wird, um die gesamte erste Verbindung auf Fluorbasis während des ersten Ätzens zu verbrauchen, um das erste Ätzen vor dem Verbrauch der gesamten Dicke der dielektrischen Schicht (14, 14f), die sich auf der Flanke (32) befindet, und nach dem Verbrauch der gesamten Dicke der dielektrischen Schicht (14, 14b), die sich auf der Oberseite (31) befindet, zu unterbrechen,
o eine erste Schutzschicht (50a) auf Oxidbasis auf der Oberseite (31) der dreidimensionalen Struktur (30) gebildet wird und eine zweite Schutzschicht (60) auf Oxidbasis auf der dielektrischen Schicht (14, 14f), die sich auf der Flanke (32) befindet, gebildet wird, wobei eine Dicke e50a der ersten Schutzschicht (50a) größer ist als eine Dicke e60a der zweiten Schutzschicht (60),
- wobei ein zweites Ätzen dazu konfiguriert ist, die zweite Schutzschicht (60) vollständig zu entfernen, während ein Abschnitt (50b) der Dicke e50b der ersten Schutzschicht (50a, 50b, 50m) beibehalten bleibt,
wobei der Ablauf des ersten und des zweiten Ätzens wiederholt wird, bis die dielektrische Schicht (14, 14f), die sich auf der Flanke (32) der dreidimensionalen Struktur (30) befindet, vollständig entfernt ist,
wobei das Verfahren **dadurch gekennzeichnet ist, dass** das zweite Ätzen durch Plasma auf Wasserstoffbasis, wie Diwasserstoff (H2) oder Ammoniak (NH3) durchgeführt wird.

2. Verfahren nach dem vorhergehenden Anspruch, wobei das zweite Ätzen dazu konfiguriert ist, einen oberen Abschnitt (14m) der dielektrischen Schicht (14, 14f), die sich auf der Flanke (32) befindet, durch Implantation von Spezies auf Wasserstoffbasis zu modifizieren.

3. Verfahren nach einem der vorhergehenden Ansprüche, wobei das Plasma auf Wasserstoffbasis des zweiten Ätzens fluorfrei ist.

4. Verfahren nach einem der vorhergehenden Ansprüche, wobei das Plasma des zweiten Ätzens aus Diwasserstoff (H2) oder Ammoniak (NH3) und mindestens einer Spezies X gebildet wird, die die Dissoziation von Diwasserstoff oder Ammoniak fördert, wobei die mindestens eine Spezies X aus Stickstoff, Helium, genommen wird.

5. Verfahren nach einem der vorhergehenden Ansprüche, wobei das Plasma auf Wasserstoffbasis des zweiten Ätzens entlang der Richtung (Z) parallel zur Flanke (32) der Struktur (30) anisotrop ist.

6. Verfahren nach einem der vorhergehenden Ansprüche, wobei das Plasma auf Wasserstoffbasis des zweiten Ätzens eine Polarisationsspannung von weniger als 250 V und vorzugsweise von weniger als 150 V aufweist.

7. Verfahren nach einem der vorhergehenden Ansprüche, umfassend einen Ablauf des ersten und des zweiten anfänglichen Ätzens, und wobei, während ein Ablauf des ersten und des zweiten nachfolgenden Ätzens wiederholt wird, das erste nachfolgende Ätzen eine längere Dauer aufweist als die des ersten anfänglichen Ätzens.

8. Verfahren nach einem der vorhergehenden Ansprüche, wobei das erste Ätzen dazu konfiguriert ist, die erste auf Oxidbasis gebildete Schutzschicht (50a) eine Dicke e50a von größer gleich 5 nm aufweist.

9. Verfahren nach einem der vorhergehenden Ansprüche, wobei das zweite Ätzen dazu konfiguriert ist, der zurückbleibende Abschnitt der ersten Schutzschicht (50b) eine Dicke e50b von größer gleich 2 nm aufweist.

10. Verfahren nach einem der vorhergehenden Ansprüche, umfassend einen vorläufigen Schritt des Ätzens der dielektrischen Schicht (14), der vor der Schrittfolge durchgeführt wird, wobei der vorläufige Schritt des Ätzens unterbrochen wird, um einen Abschnitt der dielektrischen Schicht (14, 14b), der sich auf der Oberseite (31) der dreidimensionalen Struktur (30) befindet, beizubehalten.

11. Verfahren nach einem der vorhergehenden Ansprüche, wobei die zweite Schutzschicht (60) auf Oxidbasis auf einem oberen Abschnitt der dielektrischen Schicht (14, 14f), der sich auf der Flanke (32) befindet, gebildet wird.

12. Verfahren nach einem der vorhergehenden Ansprüche, umfassend einen vorläufigen Schritt des Oxidierens der dielektrischen Schicht (14), der vor der Schrittfolge durchgeführt wird, wobei der vorläufige Schritt des Oxidierens dazu bestimmt ist, ein seitliches Ätzen der dielektrischen Schicht (14, 14g) während des ersten Ätzens zu begrenzen.

13. Verfahren nach einem der vorhergehenden Ansprüche, wobei die Struktur (30) aus einem Halbleitermaterial besteht und einen Kanal (110) eines FinFET-Transistors bildet.

14. Verfahren zur Herstellung eines FinFET-Transistors (100), der ein Trägersubstrat (10) überragt, wobei der FinFET-Transistor (100) ein Gate (130) und mindestens einen Kanal (110), der durch das Gate (130) verläuft und sich von einer Flanke des Gates (130) aus erstreckt, um mindestens eine Struktur (30) aus einem Halbleitermaterial zu bilden, umfasst,
wobei die Struktur (30) eine Oberseite (31) und mindestens zwei Flanken (32) aufweist, wobei das Verfahren Folgendes umfasst:
- Abscheiden einer dielektrischen Schicht (14), die das Gate (130) und die Struktur (30) bedeckt,
- Ätzen der dielektrischen Schicht (14) durch Anwenden des Verfahrens nach einem der vorhergehenden Ansprüche, um die dielektrische Schicht (14, 14f, 14b), die sich auf der durch den Kanal (110) gebildeten Struktur (30) befindet, vollständig zu entfernen.

15. Verfahren nach einem der vorhergehenden Ansprüche, wobei der Transistor (100) eine Hartmaske (150) aufweist, die eine Oberseite des Gates (130) bedeckt, wobei die dielektrische Schicht (14, 14b) auf der Hartmaske (150) abgeschieden wird, wobei die Hartmaske (150) eine Dicke e150 aufweist, so dass e150 ≥ e30 ist, wobei e30 die Höhe der Struktur (30) ist, und vorzugsweise e150 ≥ 1,2 * e30.

## Claims

1. A method for etching a dielectric layer (14) covering at least a top (31) and a flank (32) of a three-dimensional structure (30), said method comprising a plurality of sequences each comprising at least the following successive steps:
- a first etching of the dielectric layer (14), by plasma, using chemistry comprising:
o at least a first fluorine-based compound (F) coming from dissociation of at least one compound selected from fluorocarbon compounds CxFz or CxHyFz, x, y and z being non-zero integers, and
o at least a second compound selected from SiwCl(2w+2) and SiwF(2w+2), w being non a non-zero integer,
o oxygen (0),
said first etching being performed so as to:
o generate an ion bombardment mainly directed along a direction (Z) parallel to said flank (32),
o regulate the amount of the at least one first compound to consume all said first fluorine-based compound during this first etching so as to interrupt the first etching before consuming the entire thickness of the dielectric layer (14, 14f) located on the flank (32) and after consuming the entire thickness of the dielectric layer (14, 14b) located on the top (31),
o form a first oxide-based protective layer (50a) on the top (31) of the three-dimensional structure (30) and form a second oxide-based protective layer (60) on the dielectric layer (14, 14f) located on the flank (32), a thickness e50a of the first protective layer (50a) being greater than a thickness e60a of the second protective layer (60),
- a second etching configured to entirely remove the second protective layer (60) while keeping a portion (50b) having a thickness e50b of the first protective layer (50a, 50b, 50m), said sequence of first and second etchings being repeated until the dielectric layer (14, 14f) located on the flank (32) of the three-dimensional structure (30) is completely removed,
said method being **characterised in that** the second etching is performed by hydrogen-based plasma, such as dihydrogen (H2) or ammonia (NH3).

2. The method according to the preceding claim, wherein the second etching is configured to modify an upper portion (14m) of the dielectric layer (14, 14f) located on the flank (32), by implanting hydrogen-based species.

3. The method according to any of the preceding claims, wherein the hydrogen-based plasma of the second etching is free of fluorine.

4. The method according to any of the preceding claims, wherein the plasma of the second etching is formed from dihydrogen (H2) or ammonia (NH3) and at least one species X promoting dissociation of dihydrogen or ammonia, said at least one species X being selected from nitrogen, helium.

5. The method according to any of the preceding claims, wherein the hydrogen-based plasma of the second etching is anisotropic along the direction (Z) parallel to the flank (32) of the structure (30).

6. The method according to any of the preceding claims, wherein the hydrogen-based plasma of the second etching has a bias voltage of less than 250 V, and preferably less than 150 V.

7. The method according to any of the preceding claims, comprising a sequence of initial first and second etchings, and wherein, when repeating a sequence of subsequent first and second etchings, the first subsequent etching has a duration greater than the initial first etching.

8. The method according to any of the preceding claims, wherein the first etching is configured so that the first oxide-based protective layer (50a) formed, has a thickness e50a greater than or equal to 5 nm.

9. The method according to any of the preceding claims, wherein the second etching is configured so that the portion of the first protective layer (50b) kept, has a thickness e50b greater than or equal to 2 nm.

10. The method according to any of the preceding claims, comprising a prior step of etching the dielectric layer (14), performed before said sequence of steps, the prior etching step being interrupted so as to keep a portion of the dielectric layer (14, 14b) located on the top (31) of the three-dimensional structure (30).

11. The method according to any of the preceding claims, wherein the second oxide-based protective layer (60) is formed on a upper portion of the dielectric layer (14, 14f) located on the flank (32).

12. The method according to any of the preceding claims, comprising a prior step of oxidising the dielectric layer (14), performed before said sequence of steps, the prior oxidation step being for limiting a side etching of the dielectric layer (14, 14g) during the first etching.

13. The method according to any of the preceding claims, wherein the structure (30) is of a semiconductor material and forms a channel (110) of a FinFET transistor.

14. A method for making a FinFET transistor (100) over a support substrate (10), the FinFET transistor (100) comprising a gate (130) and at least one channel (110) passing through the gate (130) and extending from a flank of the gate (130) to form at least one structure (30) of a semiconductor material,
said structure (30) having a top (31) and at least two flanks (32), the method comprising:
- depositing a dielectric layer (14) covering the gate (130) and said structure (30),
- etching the dielectric layer (14) by implementing the method according to any of the preceding claims, so as to completely remove the dielectric layer (14, 14f, 14b) located on the structure (30) formed by the channel (110).

15. The method according to the preceding claim, wherein the transistor (100) has a hard mask (150) covering a top of the gate (130), the dielectric layer (14, 14b) being deposited onto the hard mask (150), the hard mask (150) having a thickness e150, such that e150 ≥ e30, e30 being the height of the structure (30), and preferably e150 ≥ 1.2× e30.
